# EUROPEAN PATENT APPLICATION

(11) **EP 4 557 361 A1**
(43) Date of publication of application: **21.05.2025**
(21) Application number: 23210441.4
(22) Date of filing: 16.11.2023
(51) Int. Cl.: H01L 23/482, H01L 29/20, H01L 29/417, H01L 29/778

(54) **GROUP III NITRIDE TRANSISTOR DEVICE AND METHOD FOR FABRICATING A GROUP III NITRIDE TRANSISTOR DEVICE**

(71) Applicant: Infineon Technologies Austria AG, 9500 Villach (AT)
(72) Inventor: GIETLER, Herbert, 9500 Villach (AT)
(74) Representative: JENSEN & SON

(57) **Abstract**

According to an embodiment, a Group III nitride transistor device is provided that comprises a Group III nitride substrate comprising first major surface, a Group III nitride channel layer and a Group III nitride barrier layer arranged on the Group III nitride channel layer and forming a heterojunction therebetween, a plurality of transistor cells and a metallization structure comprising a first electrically conductive layer and a second electrically conductive layer. The first electrically conductive layer comprises for each transistor cell a source finger and a drain finger arranged on the first major surface, and the second electrically conductive layer comprises a source bus and a drain bus. The source bus extends between and electrically connects the source fingers of the plurality of transistor cells and extends over and is electrically insulated from the drain fingers. The drain bus extends between and electrically connects the drain fingers of the plurality of transistor cells and extends over and is electrically insulated from the source fingers. In at least one of the transistor cells an area of overlap between the source finger and the source bus is greater than an area of overlap between the same source finger and the drain bus and/or in at least one of the transistor cells an area of overlap between the drain finger and the drain bus is greater than an area of overlap between the same drain finger and the source bus.

## Description

### BACKGROUND

To date, transistors used in power electronic applications have typically been fabricated with silicon (Si) semiconductor materials. Common transistor devices for power applications include Si CoolMOSO, Si Power MOSFETs, and Si Insulated Gate Bipolar Transistors (IGBTs). More recently, silicon carbide (SiC) power devices have been considered. Group III-N semiconductor devices, such as gallium nitride (GaN) devices, are now emerging as attractive candidates to carry large currents, support high voltages and to provide very low on-resistance and fast switching times. Further improvements to Group III nitride transistor device are desirable.

### SUMMARY

According to the invention, a Group III nitride transistor device is provided that comprises a Group III nitride substrate comprising first major surface, a Group III nitride channel layer and a Group III nitride barrier layer arranged on the Group III nitride channel layer and forming a heterojunction therebetween, a plurality of transistor cells and a metallization structure comprising a first electrically conductive layer and a second electrically conductive layer. The first electrically conductive layer comprises for each transistor cell a source finger and a drain finger arranged on the first major surface, and the second electrically conductive layer comprises a source bus and a drain bus. The source bus extends between and electrically connects the source fingers of the plurality of transistor cells and extends over, and is electrically insulated from, the drain fingers. The drain bus extends between and electrically connects the drain fingers of the plurality of transistor cells and extends over, and is electrically insulated from, the source fingers. In at least one of the transistor cells an area of overlap between the source finger and the source bus is greater than an area of overlap between the same source finger and the drain bus and/or in at least one of the transistor cells an area of overlap between the drain finger and the drain bus is greater than an area of overlap between the same drain finger and the source bus.

The Group III nitride transistor device is a lateral device and the metallization structure serves to electrically couple the plurality of transistor cells in parallel. The Group III nitride transistor device has reduced switching losses since the output capacitance, C_{DS}, is reduced the output capacitance C_{DS} by the metallization structure having a smaller area of overlap between the drain finger and the source bus than the area of overlap between that drain finger and the drain bus and/or a smaller area of overlap between the source finger and the drain bus than the area of overlap between that source finger and the source bus.

The first and second electrically conductive layers and consequently the source and drain fingers of the first electrically conductive layer and the source and drain bus of the second electrically conductive layer are arranged in two horizontal or lateral planes that are spaced apart in the vertical direction. The source bus overlaps, i.e. extends over and covers part of the source fingers and drain fingers, and the drain bus overlaps, i.e. extends over and covers part of the source fingers and drain fingers.

The second conductive layer is arranged on the first major surface above the first conductive layer such that the source bus is arranged above and extends over the source fingers and drain fingers, whereby the source bus is electrically connected to the source fingers and is electrically insulated from the drain fingers and the drain bus is arranged above and extends over the source fingers and drain fingers, whereby the drain bus is electrically connected to the drain fingers and is electrically insulated from the source fingers.

The metallization structure may further comprise at least one electrically insulating layer arranged between the first and second conductive layer. The source bus may be electrically connected to each of the source fingers of the plurality of transistor cells by one or more conductive vias extending between each source finger and the source bus. The drain bus may be electrically connected to each of the drain fingers of the plurality of transistor cells by one or more conductive vias extending between each drain finger and the drain bus.

The source bus is electrically insulated from the drain fingers by the intervening electrically insulating layer and the drain bus is electrically insulated from the source fingers by the intervening electrically insulating layer.

The first and second electrically conductive layer and the electrically insulating layer may each comprise two or more sublayers.

The Group III nitride transistor device may further comprise a gate and be a lateral device with the source, drain and gate arranged on the first major surface. In each transistor cell of the Group III nitride transistor device, the gate is laterally arranged between the source and the drain. The source and/or drain may be common to two neighbouring transistor cells.

In some embodiments, the gate of each transistor cell comprises a gate finger arranged on the first major surface. The gate finger may be laterally arranged between a source contact and a drain contact arranged on the first major surface.

The source contact, drain contact and gate finger may be elongate and have a strip-like structure and extend substantially parallel to one another. The gate finger may be formed of a different material from the source contact and drain contact.

The Group III nitride transistor device may comprise a die conductive layer which comprises the source contact and the drain contact. The die conductive layer is arranged on the first major surface between the first conductive layer of the metallization structure and the first major surface of the Group III nitride substrate. The gate finger may be separate from the die conductive layer and from the first conductive layer. One or more passivation layers are arranged on the die conductive layer and the gate finger and the first electrically conductive layer of the metallization structure is arranged on the passivation layer(s).

The source contact extends parallel to and underneath the source finger of the first conductive layer and the drain contact extends parallel to and underneath the drain finger of the first conductive layer. The source contact is electrically connected to the source finger by an elongate conductive via that extends through the at least one passivation layer. The drain contact is electrically connected to the drain finger by an elongate conductive via that extends through the at least one passivation layer.

The Group III nitride transistor device may be a HEMT (High Electron Mobility Transistor) in which a two-dimensional charge gas, e.g. a two-dimensional electron gas or two-dimensional hole gas is formed at the heterojunction between the channel layer and barrier layer. The Group III nitride channel layer may be formed of GaN and the Group III nitride barrier layer may be formed of AlGaN.

In some embodiments, the section of the source finger that is located under the drain bus has an area that is less than the area of that source finger that is located under the source bus. The area of overlap between an individual one of the source fingers and the drain bus may be reduced in various ways. In some embodiments, the lateral shape of the source fingers in the first conductive layer is modified.

In some embodiments, the section of the drain finger that is located under the source bus has an area that is less than the area of that drain finger that is located under the drain bus. The area of overlap between an individual one of the drain fingers and the source bus may also be reduced in various ways. In some embodiments, the lateral shape of the drain fingers in the first conductive layer is modified.

In some embodiments, the source fingers each have a length and a width. The length is greater than the width so as to form a strip-like finger shape. The width of a first section of the source finger that is located under the drain bus is less than the width of a second section of that source finger that is located under the source bus. In some embodiments, the drain fingers each have a length and a width. The length is greater than the width so as to form a strip-like finger shape. The width of a first section of the drain finger that is located under the source bus is less than the width of a second section of that drain finger that is located under the drain bus.

In some embodiments, the first section of the source finger that is located under the drain bus has a tapered shape in plan view, for example is triangular or funnelshaped in plan view, and/or the first section of the drain finger that is located under the source bus has a tapered shape in plan view, for example triangular or funnelshaped in plan view.

In some embodiments, the source finger comprises an opening intermediate its length and width and the opening is located under the drain bus, and/or the drain finger comprises an opening intermediate its length and width and the opening is located under the source bus. The opening may also be called an aperture or hole and extends through the thickness of the source finger or drain finger.

The above structures and modified shapes for the source fingers and drain fingers may be combined in order to reduce the area of overlap with the drain bus and source bus, respectively.

The source bus and the drain bus are laterally spaced apart from one another for example by a gap in the second conductive layer. In some embodiments, the source bus has a length and a width, the length extending substantially perpendicularly to the length of the source finger and the width being substantially the same in the section located above the source fingers and in the section located above the drain fingers and/or the drain bus has a length and a width, the length extending substantially perpendicularly to the length of the source finger and the width being substantially the same in the section located above the source fingers and in the section located above the drain fingers. The source bus and the drain bus may be substantially a rectangular shape in plan view with the length being greater than the respective width. The source bus and the drain bus may extend parallel to one another.

The above structures and modified shapes for the source fingers and drain fingers may be combined with above structures and modified shapes of the source bus and drain bus.

In some embodiments, each transistor cell further comprises a gate finger arranged on the first major surface and the gate fingers each have a length and a width, wherein the width of the section of the gate finger located under the source bus and in the section of the gate finger located under the drain bus is substantially the same.

The length of the gate finger is greater than the width. The gate fingers extend substantially parallel to the source and drain fingers. One gate finger is arranged between a source finger and a drain finger.

In some embodiments, the metallization structure further comprises an electrically insulating layer arranged between the first and second electrically conductive layers, wherein at least two of the source fingers of the plurality of transistor cells are each electrically connected to the source bus by a conductive via that extends through the electrically insulating layer and/or wherein at least two of the drain fingers of the plurality of transistor cells are each electrically connected to the drain bus by a conductive via.

In some embodiments, the width of the section of the source finger located under the source bus is greater than the width of the section of drain finger located under the drain bus.

In some embodiments, the smallest width of the source finger is the same as or greater than the smallest width of the drain finger.

In some embodiments, the source bus is laterally spaced apart from the drain bus by a gap, wherein the width of the section of the source finger located in the gap is substantially the same as the width of the section of the source finger located under the source bus and/or the width of the section of the drain finger located in the gap is substantially the same as the width of the section of the drain finger located under the drain bus.

In some embodiments, the area of overlap between the individual ones of the source fingers and the drain bus may be reduced by modifying the shape of the drain bus in the second conductive layer. The area of overlap between the individual ones of the drain fingers and the source bus may be reduced by modifying the shape of the source bus in the second conductive layer.

In some embodiments, the source bus and/or the drain bus comprises at least one aperture. One or more apertures may be located laterally adjacent the conductive vias which extend between the source fingers and the source bus and/or between the drain fingers and the drain bus.

The Group III nitride substrate may further comprise a Group III nitride buffer structure arranged on a substrate having a composition other than a Group III nitride. In some embodiments, the Group III nitride channel layer is arranged directly on the buffer structure. In some embodiments, a back barrier layer that forms a heterojunction with Group II nitride channel layer is arranged between the Group III nitride channel layer and the buffer layer.

The substrate may comprise an upper or growth surface which is capable of supporting the epitaxial growth of one or more Group III nitride-base layers. In some embodiments, the substrate is a foreign substrate, i.e. is formed of a material other than Group III nitride materials and includes the upper or growth surface which is capable of supporting the epitaxial growth of one or more Group III nitride-base layers.

The common substrate may be formed of silicon and may be formed of monocrystalline silicon or an epitaxial silicon layer, for example, or sapphire. The buffer structure may comprise a transition layer on the growth surface of the substrate and a superlattice structure on the transition layer.

The first and second electrically conductive layers may be formed of copper or a copper alloy. The electrically insulating layer may be formed of an oxide such as silicon oxide and/or a nitride such as silicon nitride.

According to the invention, a method for fabricating a Group III nitride transistor is also provided. The method comprises providing a Group III nitride transistor having an initial design. The initial design comprises a Group III nitride substrate comprising first major surface, a Group III nitride channel layer and a Group III nitride barrier layer arranged on the Group III nitride channel layer and forming a heterojunction therebetween, a plurality of transistor cells and a metallization structure comprising a first electrically conductive layer and a second electrically conductive layer. The first electrically conductive layer comprises for each transistor cell a source finger and a drain finger on the first major surface. The second electrically conductive layer comprises a source bus and a drain bus. The source bus extends between and electrically connects the source fingers of the plurality of transistor cells and extends over and is electrically insulated from the drain fingers such that for each transistor cell a first initial overlapping area between the drain finger and the source bus is formed. The drain bus extends between and electrically connects the drain fingers of the plurality of transistor cells and extends over and is electrically insulated from the source fingers such that for each transistor cell a second initial overlapping area between the source finger and the drain bus is formed. The method further comprises measuring the capacitance between the source finger and the drain bus in the initial design and/or measuring the capacitance between the drain finger and the source bus in the initial design, measuring the on-state resistance of the Group III nitride transistor device in the initial design, locally reducing the first and/or second initial overlapping area and forming a first and/or second modified overlapping area and a producing modified design having the reduced first and/or second overlapping area.

In some embodiments, the method continues by outputting a dataset including the modified design. This dataset may be used to fabricate one or more lithographic masks or structure these lithographic masks which are used for forming the source and drain fingers.

In some embodiments, the method further comprises measuring the new capacitance between the source finger and the drain bus in the modified design and/or measuring the new capacitance between the drain finger and the source bus in the modified design.

In some embodiments, the method further comprises forming a source finger and/or a drain finger according to the modified design.

In some embodiments, the capacitance between the source finger and the drain bus and the on-state resistance of the Group III nitride transistor device in the initial design is measured and the first initial overlapping area is reduced to form a first modified overlapping area. In some embodiments, the capacitance between the drain finger and the source bus and the on-state resistance of the Group III nitride transistor device is measured in the initial design and the second initial overlapping area is reduced to form a second modified overlapping area.

In some embodiments, the first and/or second initial overlapping area is locally reduced by reducing the area of one or both of the source finger and the drain bus in the first initial overlapping area and/or reducing the area of one or both of the drain finger and the source bus in the second initial overlapping area.

In some embodiments, in the initial design, the source finger has an initial width, an initial length and an initial lateral shape. In some embodiments, the initial lateral shape is rectangular and the area of the source finger is reduced by reducing the initial width of the source finger in the first initial overlapping area without reducing the initial length, and/or by introducing an aperture intermediate the initial length and the initial width of the source finger in the first initial overlapping region and/or reducing the initial width by forming a tapering shape from the rectangular initial lateral shape in the first initial overlapping area.

In some embodiments, in the initial design, the drain finger has an initial width, an initial length and an initial lateral shape. In some embodiments, the initial lateral shape is rectangular and the area of the drain finger is reduced by reducing the initial width of the drain finger in the second initial overlapping area without reducing the initial length, and/or by introducing an aperture intermediate the initial length and the initial width of the drain finger in the second initial overlapping region and/or reducing the initial width by forming a tapering shape from the rectangular initial lateral shape in the second initial overlapping area.

In some embodiments, an area of overlap between the source finger and the source bus is greater than an area of overlap between the same source finger and the drain bus and/or an area of overlap between the drain finger and the drain bus is greater than an area of overlap between the same drain finger and the source bus.

In some embodiments, the first initial overlapping area between the source finger and the drain bus is reduced in comparison to an area of overlap between the same source finger and the source bus and/or the second initial overlapping area between the drain finger and the source bus is reduced in comparison to an area of overlap between the same drain finger and the drain bus.

In some embodiments, in the initial design, the drain bus has an initial area and the method further comprises forming at least one aperture in the drain bus and/or removing peripheral portions of the drain bus. In some embodiments, in the initial design, the source bus has an initial area and the method further comprises forming at least one aperture in the source bus and/or removing peripheral portions of the source bus. The peripheral regions of the source bus and drain bus may be located laterally outside of the active switching area of the transistor device, whereas the aperture may be located above and within the lateral area of the active switching area of the transistor device.

Portions of the drain bus outside of the active switching area of the transistor device may be removed in regions laterally adjacent the distal ends of the source and drain fingers, and/or adjacent the length of the source and drain fingers and/or in the peripheral regions of the substrate. Portions of the source bus may be removed in regions laterally adjacent the distal ends of the source and drain fingers, and/or adjacent the length of the source and drain fingers and/or in the peripheral regions of the substrate.

In some embodiments, the relationship between the on-state resistance and the output capacitance is further optimised. In some embodiments, the method further comprises measuring the new on state resistance of the modified design. If the new capacitance is less than the initial capacitance and the on-state resistance is less than a predetermined threshold value, the lateral size and shape of the source finger is output in a final design dataset. A source finger and a drain finger are then formed according to the final design dataset. If the new capacitance is less than the initial capacitance and the on-state resistance is equal to or greater than a predetermined threshold value, increasing the area of the source finger, the method is repeated by returning to measuring the on-sate resistance and the new capacitance of the new modified design.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Fig. 1 illustrates a circuit diagram of a transistor device.
Figure 2A illustrates a top view and figure 2B a cross-sectional view of a comparison transistor device, figure 2C illustrates a top view and figure 2D a cross-sectional view of a Group III nitride transistor device according to an embodiment and figure 2E illustrates an enlarged cross-sectional view of figure 2D.
Figure 3A illustrates a top view of a comparison Group III nitride transistor device and figure 3B illustrates a top view of Group III nitride transistor device according to an embodiment.
Figure 4 illustrates a top view of a portion of the metallization structure of Group III nitride device according to an embodiment.
Figure 5A illustrates a top view of the metallization structure of a comparison Group III nitride transistor device and figure 5B illustrates a top view of the metallization structure of a Group III nitride transistor device according to an embodiment.
Figure 6 illustrates a flow chart of a method of fabricating a Group III nitride transistor device.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

A depletion-mode device, such as a high-voltage depletion-mode transistor, has a negative threshold voltage which means that it can conduct current at zero gate voltage. These devices are normally on. An enhancement-mode device, such as a low-voltage enhancement-mode transistor, has a positive threshold voltage which means that it cannot conduct current at zero gate voltage and is normally off. An enhancement-mode device is not limited to low voltages and may also be a high-voltage device.

As used herein, the phrase "Group III-Nitride" refers to a compound semiconductor that includes nitrogen (N) and at least one Group III element, including aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), and aluminum indium gallium arsenide phosphide nitride (AlₓIn_{y}Ga_{(1-x-y)}AsₐP_{b}N_{(1-a-b)}), for example. Aluminum gallium nitride and AlGaN refers to an alloy described by the formula AlₓGa₍₁₋ₓ₎N, where 0 < x < 1.

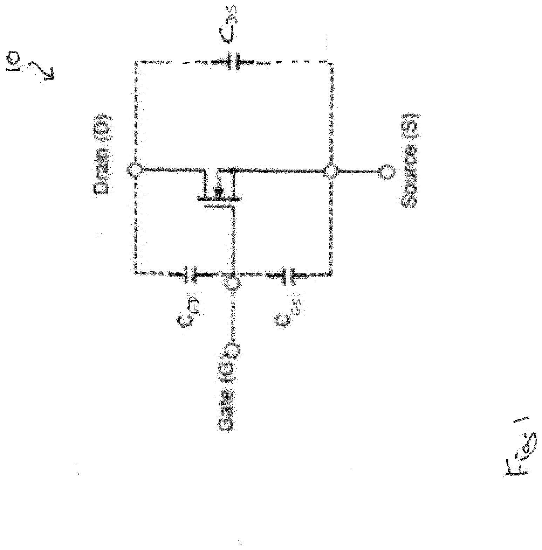

Figure 1 illustrates a circuit diagram of a Group III transistor device 10 which includes a source (S), a drain (D) and a gate (G) terminal. Figure 1 also indicates the capacitance, C_{GD}, formed between the gate and drain, the capacitance, C_{GS}, formed between the gate and source and the output capacitance, C_{DS}, formed between the drain and source.

The transistor device 10 comprises a plurality of transistor cells that are formed in a semiconductor substrate and which are electrically coupled in parallel. The transistor device 10 further comprises a metallization structure which is used to electrically connect the individual transistor cells to one another and which provides a redistribution structure between the transistor cells and contact areas.

In order to reduce the switching losses, it is proposed herein to reduce the output capacitance C_{DS}. In particular, it is proposed to reduce the output capacitance C_{DS} by providing an improved metallization structure. The measures described herein may be used together with measures to reduce the on-state resistance (Ron) in order to reduce the total losses of a Group III nitride transistor device.

Lateral Group III nitride transistor devices, for example HEMTs, are provided which are suitable for fast switching applications and which have a metallization structure with a structure which results in low Ron-losses and lower switching losses. To reduce the switching losses, the effect of the metallization structure on the output capacitance C_{DS} is taken into account by suitable structuring of the metallization structure. The metallization structure may be designed as a compromise between Rₒₙ and output capacity C_{DS}.

In some embodiments, the metallization structure comprises two metal layers that are arranged in a stack with an interlayer dielectric arranged between them in the stack. In some embodiments, the width of the first lower drain metal layer is reduced in areas with a low current density and/or low Rₒₙ-influence and/or where a second source metal layer is above. In some embodiments, the width of the first source metal layer is reduced in areas with a low current density and/or low Rₒₙ-influence and/or where a second drain metal layer is above. These measures can be used without changing the thickness of the interlayer dielectric that is arranged between the two metal layers thus avoiding processes issues that may arise when forming conductive vias through thicker interlayer dielectrics.

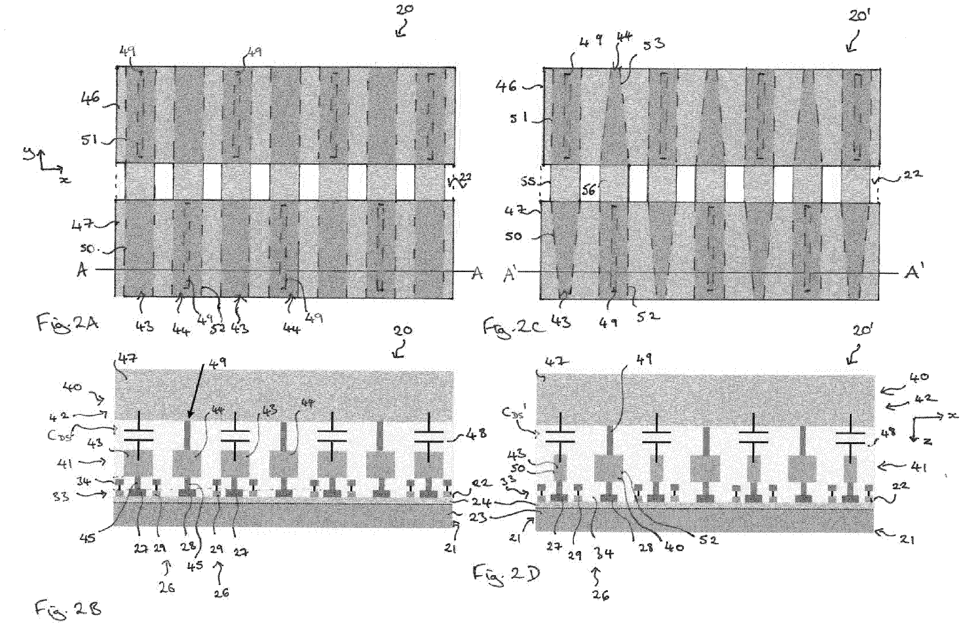

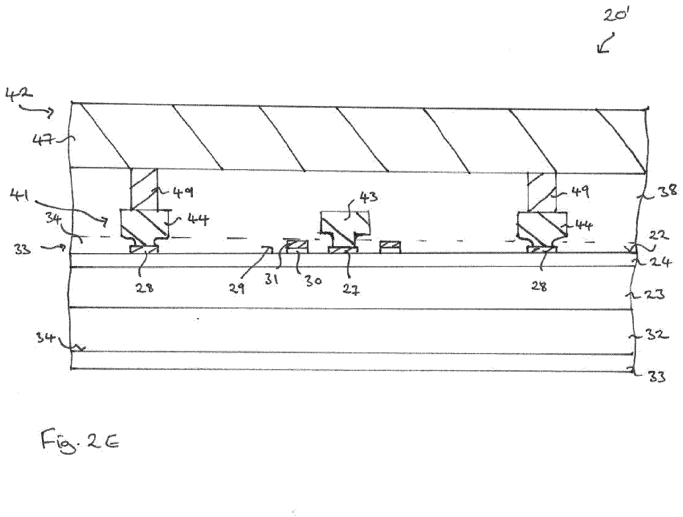

Figure 2A illustrates a top view and figure 2B a cross-sectional view along the line A-A of figure 2A of a portion of a comparison Group III nitride transistor device 20. Figure 2C illustrates a top view and figure 2D a cross-sectional view along the line A'-A' of figure 2C of a portion of a Group III nitride transistor device 20' according to an embodiment which comprises a reduced output capacitance CDS. Figure 2E illustrates an enlarged cross-sectional view of the Group III nitride transistor device 20'.

Referring to the cross-sectional views of figures 2B, 2D and 2E, the Group III nitride transistor device 20, 20' includes a Group III nitride substrate 21 having a first major surface 22, a Group III nitride channel layer 23 and a Group III nitride barrier layer 24 arranged on the Group III nitride channel layer 23. The Group III nitride barrier layer 24 and channel layer 23 have different compositions and bandgaps such that a heterojunction is formed between the Group III nitride barrier layer 24 and the Group III nitride channel layer 23. For example, the Group III nitride channel layer 23 may be formed of GaN and the Group III nitride barrier layer 24 may be formed of AlGaN. A two-dimensional charge gas, for example a two-dimensional electron gas (2DEG) may be formed by spontaneous and piezoelectric polarization at the heterojunction 25 and is indicated schematically by a dashed line.

The Group III nitride device 30 comprises a plurality of transistor cells 26 each comprising a source contact 27, a drain contact 28 and a gate finger 29, which is arranged laterally between the source contact 27 and the drain contact 28, and formed on the first major surface 22. The source contact 27 and drain contact 28 are part of a die conductive layer 33 that is arranged on the first major surface 22 and covered by a passivation layer 34. The source and drain contacts 27, 28 may be common to neighbouring ones of the transistor cells 26 so that a repeating pattern of: source gate drain gate source gate drain is formed on the first major surface 22. Each of the source contact 27, drain contact 28, and gate finger 29 may have an elongate stripe like structure with a length extending in the y direction using the Cartesian coordinate system and a width extending in the x direction, the length being longer than the width. The first major surface 22 lies in the x-y plane and the thickness of the Group III nitride substrate 21 in the z direction. The source contact 27, drain contact 28 and gate finger 29 extend substantially parallel to one another. The source contact 27 and the drain contact 28 may form an ohmic contact to the Group III nitride substrate 21.

As can be seen in the enlarged view of figure 2E, the gate finger 29 may include a p doped Group IIII nitride layer 30, for example p doped gallium nitride, and a gate metal layer 31 which is arranged on the p doped Group IIII nitride layer 30. This structure for the gate finger 29 provides an enhancement mode device which is normally off. In other embodiments, the gate finger 29 may have a recessed gate structure with the gate finger being formed in a recess formed in the first major surface 22 such that the Group III nitride barrier layer 24 under the recess has a smaller thickness than the thickness of the barrier layer laterally adjacent to the gate finger 29. A recessed gate structure may also be used to provide an enhancement mode device. The gate metal 31 may form an ohmic contact or a Schottky contact.

In some embodiments, ohmic contacts have a multilayer structure, for example Ti, Al and a capping metal such as Ti. Schottky metal contacts may be formed of one or more of TiN, Ti, W, WSiₓ, Ta, TaN, Ni, Pd, Pt and Ir. The Group III nitride transistor device 20 may be a HEMT (High Electron Mobility Transistor).

The Group IIII nitride channel layer 23 is arranged on a buffer structure 32 which is in turn arranged on a substrate 33. The substrate 33 includes an upper or growth surface 34 which is capable of supporting the epitaxial growth of one or more Group III nitride-based layers. In some embodiments, the substrate 33 is a foreign substrate, i.e. is formed of a material other than Group III nitride materials, and includes the upper or growth surface 34 which is capable of supporting the epitaxial growth of one or more Group III nitride-based layers. The substrate 33 may be formed of silicon, for example, monocrystalline silicon or an epitaxial silicon layer, or sapphire.

In some non-illustrated embodiments, the Group III nitride-based semiconductor substrate 21 may further include a Group III nitride back barrier layer that is arranged between the Group III nitride channel layer 23 and the buffer structure 32. The channel layer 23 is formed on the back barrier layer and forms a heterojunction with the back barrier layer. The Group III nitride barrier layer 24 is formed on the opposing side of the Group III nitride channel layer 23 to the back barrier layer. The Group III nitride back barrier layer has a different bandgap to the Group III nitride channel layer 23 and may comprise AlGaN, for example. The composition of the AlGaN of the back barrier layer may differ from the composition of the AlGaN used for the barrier layer 24.

A typical transition or buffer structure 32 for a silicon substrate includes a AIN starting layer, which may have a thickness of several 1 00nm, on the silicon substrate followed by a AlₓGa₍₁₋ₓ₎N layer sequence, the thickness again being several 100nm's for each layer, whereby the Al content of about 50-75% is decreased down to 10-25% before the GaN layer or AlGaN back barrier, if present, is grown. Alternatively, a superlattice buffer can be used. Again, an AIN starting layer on the silicon substrate is used. Depending on the chosen superlattice, a sequence of AIN and AlₓGa₍₁₋ₓ₎N pairs is grown, where the thickness of the AIN layer and AlₓGa₍₁₋ₓ₎N is in the range of 2-25nm. Depending on the desired breakdown voltage the superlattice may include between 20 and 100 pairs. Alternatively, an AlₓGa₍₁₋ₓ₎N layer sequence as described above can be used in combination with the above mentioned superlattice.

The Group III nitride transistor device 20 further comprises a metallization structure 40 which comprises a first electrically conductive layer 41 and a second electrically conductive layer 42 which is arranged above the first electrically conductive layer 41 in the z direction. The first electrically conductive layer 41 comprises for each transistor cell 26 a source finger 43 and a drain finger 44. The source finger 43 and drain finger 44 have an elongate stripe -like structure with a length extending in the y direction and a width in the x direction and extend substantially parallel to one another in the y direction. The source finger 43 is arranged vertically above the source contact 27 with the length of the source finger 43 and source contact 27 being aligned with one another and the drain finger 44 is arranged vertically above and aligned with the drain 28 contact. Each source finger 43 is electrically connected to an underlying one of the source contacts 27 by a conductive via 45 and each drain finger 44 is electrically connected to one underlying drain contact 28 by a conductive via 45. The conductive vias 45 may be elongate and extend over the majority of the length of the respective contacts. The passivation layer 34 is formed between the die conductive layer 33 and the first electrically conductive layer 41 and the conductive vias 45 extend through the passivation layer 34.

The second conductive layer 42 comprises a source bus 46 and a drain bus 47. The source bus 46 extends substantially perpendicularly to the length of the source fingers 43 and drain fingers 44. The source bus 46 may have an elongate striped like structure having a length extending in the x direction and a width extending in the y direction, the length being greater than the width. The source bus 46 extends over and electrically connects the source fingers 43 of the plurality of transistor cells 26 to one another and thereby also extends over the intervening ones of the drain fingers 44 that are arranged between the source fingers 44. The source bus 46 is electrically insulated from the drain fingers 44 by an electrically insulating layer 48 which forms an interlayer dielectric and which is arranged between the first conductive layer 41 and the second conductive layer 42 of the metallization structure 40.

Similarly, the drain bus 47 has an elongate stripe -like structure having a length extending in the x direction and a width extending in the y direction, the length being greater than the width, and extends substantially perpendicularly to the length of the source fingers 43 and drain fingers 44. The drain bus 47 extends over and electrically connects the drain fingers 44 to one another and also extends over and is electrically insulated from the intervening ones of the source fingers 43 of the first conductive layer 41. The drain bus 47 is laterally spaced apart from the source bus 46 in the y direction and extends substantially parallel to the source bus 46. In some embodiments, two or more source buses and two or more drain buses are provided.

Each of the source fingers 43 is electrically connected to the source bus 46 by a respective conductive via 49 which extends through the dielectric layer 48 and between a first section 51 of the source finger 43 that is arranged under the source bus 46 and the overlying source bus 46. The drain bus 47 is electrically connected to each of the drain fingers 43 by a respective conductive via 49 which extends between a first section 52 of the drain finger 44, which is positioned vertically underneath the drain bus 47, and the drain bus 47. The conductive vias 49 are elongated and have a strip-like shape with a length that is the same or slightly less than the width of the respective bus 46, 47.

In the comparison Group III nitride transistor device 20 illustrated in figures 2A and 2B, the width of individual ones of the source fingers 43 is uniform along its length so that the source fingers 43 each have a rectangular shape. Similarly, the width of the individual ones of the drain fingers 44 is uniform along its length so that the drain fingers 44 each have a rectangular shape. In some embodiments, the width of the source fingers 43 and the width of the drain fingers 44 is the same.

As is schematically indicated in the cross-sectional view of figure 2B, a capacitor 54 is formed between the source finger 43 and the overlying drain bus 47, since the electrically conductive source finger 43 and electrically conductive drain bus 47 are spaced apart by the electrically insulating layer 48. In the region of vertical overlap, the source finger 43 and drain bus 47 can each be considered to provide a plate of a capacitor as there is a potential difference across the dielectric layer 48 located between the source finger 43 and the overlying drain bus 47. Similarly, a capacitor 54 is also formed between the drain fingers 44 and the overlying source bus 46. These capacitors 54 formed in the metallization structure 40 contribute towards the total value of the output capacitance C_{DS} of the Group III nitride transistor device 20.

Figure 2C illustrates a top view, figure 2D cross-sectional view along the line A'-A' indicated in figure 2C and figure 2E an enlarged cross-sectional view of a Group III nitride transistor device 20' according to an embodiment which has a reduced output capacitance. In some embodiments, a reduction in the area of overlap between the source finger 43 and the overlying drain bus 47 is achieved by reducing the lateral area of the source finger 43.

The Group III transistor device 20' differs from the comparison Group III nitride transistor device 20 in that in at least one of the transistor cells 26, an area of overlap between the source finger 43 and the source bus 46 is greater than an area of overlap between that same source finger 43 and the drain bus 47. The area of overlap between each of the source fingers 43 and the source bus 46 may be greater than the area of overlap between the source fingers 43 and the drain bus 47.

Referring to the top view of figure 2C, in some embodiments, the source finger 43 has a uniform width in the first section 51 of its length which is positioned under the source bus 46. The area of that source finger 43 in the second section 50 that is arranged under the drain bus 47 is reduced relative to the area of the first section 51 of that source finger 43 arranged under the source bus 46. In an embodiment, in the second section 50 of the source finger 43 which is positioned underneath the drain bus 47, the source finger 43 has a tapered shape, i.e. its width is increasingly decreased, e.g. has a triangular or funnel form. The width of the intermediate section 55 of the source finger 43 which is arranged in the gap between the source bus 46 and the drain bus 47 and between the first and second sections 50, 51 is the same as its width in the first section 51. The width of the source finger 43 decreases from the gap in a direction under the drain bus 37 to its distal end. The conductive via 49, which extends between the source finger 43 and the source bus 46, is positioned in the wider first section 51 of the source finger 43.

The drain finger 44 of at least one of the transistor cells 26, and in some embodiments of all of the transistor cells 26, has an area of overlap with the drain bus 47 which is greater than an area of overlap between that same drain finger 44 and source bus 46. The drain finger 44 has a uniform width in a first section 52, which is arranged under and overlaps the drain bus 47. Its width in the second section 53 of that drain finger 44, which is positioned under and vertically overlaps with the source bus 46, is reduced in relation to the area of the first section 52. The second section 53 has a tapered shape, e.g. triangular-type or funnel shape in plan view. The intermediate section 56 of the drain finger 44, which is arranged in the gap formed between the source bus 46 and drain bus 47 and which is arranged between the first and second sections 52, 53, has a width that is substantially the same as its width in the first section 52.

Since the area of the first section 50 of the source finger 43 which is positioned under the drain bus 37 is smaller compared to the comparison transistor device 20, the capacitance C_{DS} formed between the source finger 43 and the overlying drain bus 47 is reduced in the Group III nitride transistor device 20'. Similarly, the capacitance C_{DS} between the tapered second section 53 of the drain finger 44 and the overlying source bus 46 is reduced compared to the arrangement of the comparison Group III nitride transistor 20' as the area of overlap between the drain finger 44 and the source bus 46 is reduced. The Group III nitride transistor device 20' has a reduced output capacitance C_{DS} and, therefore lower switching losses.

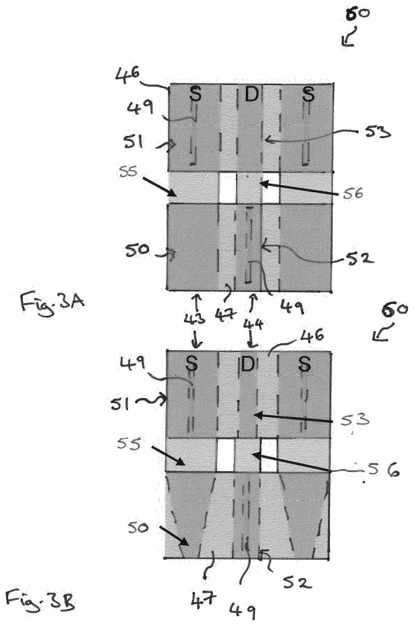

Figure 3A illustrates a top view of a portion of a comparison Group III nitride transistor device 60 and figure 3B a top view of a portion of a Group III nitride transistor device 60' according to an embodiment.

Referring to figure 3A, similar to the Group III nitride transistor device 20, the width of each of the source fingers 43 of the Group III nitride transistor device 60 is uniform over its length and therefore in the first section 51 arranged under the source bus 46, in the intermediate section 55 and in the second section 50 arranged under the drain bus 47. Similarly, the width of each of the drain fingers 44 is uniform over its length and therefore in the second section 53 arranged under the source bus 46, the intermediate section 56 and in the first section 52 arranged under the drain bus 47. The comparison Group III nitride transistor 60 illustrated in figure 3A differs from the comparison Group III nitride transistor device 20 illustrated in figure 2A in that the width of the source fingers 43 over the entire length of the source fingers 43 is greater than the width of the drain fingers 44 over the entire length of the drain fingers 44.

Referring to figure 3B, in the Group III nitride transistor device 60' according to an embodiment, the second section 50 of the individual ones of the source fingers 43 has a tapered shape in the area of overlap between that second section 50 of the source finger 43 and the overlying drain bus 47. The width of the second section 53 of the drain finger 44 positioned vertically under the source bus 46 is less than its width in the first section 52 of that drain finger 44 that is positioned vertically under the drain bus 47. In some embodiments, the reduced width of the second section 53 of the drain finger 44 positioned under the source bus 46 may be substantially uniform in this section 53 so that the second section 53 has a rectangular shape, as shown in figure 3B. In other embodiments, the second section 53 may have a tapered shape. Additionally, the width of the source fingers 43 over the entire length of the source fingers 43 is greater than the width of the drain fingers 44 over the entire length of the drain fingers 44.

The width of the intermediate section 55 of the source finger 43 which is located in the gap between the source bus 46 and the drain bus 47 is substantially the same as its width in the first section 51 positioned vertically under the source bus 46. Similarly, the width of the intermediate section 56 of the drain finger 44 which positioned in the gap between the source bus 46 and the drain bus 47 is substantially the same as its width of the first section 52 of that drain finger 44 that is positioned vertically under the drain bus 47.

As an example, the first section 51 of the source finger 43 under the source bus 46 may have a width of around 13 µm and the source finger 43 may taper to a width of around 4 µm in the second section 50 positioned under the drain bus 47. The width of the first section 52 of the drain finger 44 positioned under the drain bus 47 may be around 5 µm and the width of the second section 53 of that same drain finger 44 positioned under the source bus 46 may be around 4 µm.

Reducing the area of the source fingers 43 and drain fingers 44 may lead to a slight increase in the on-state resistance Ron due to the reduction in the conductive area. However, for a given reduction in area of the source fingers 43 and drain fingers 44, the resulting reduction in the output capacitance is larger than the resulting increase in Ron. For the example given above, C_{DS} may be reduced by 13%, whereas Ron is increased by less than 1%, thus a Group III nitride transistor device with lower switching losses overall can be provided.

Consequently, in some embodiments, the amount of the reduction of the area of the second section 50 of the source finger 43 positioned under the drain bus 47 and the amount of the reduction in the area of the second section 53 of the drain finger 44 positioned under the source bus 46 is selected as a trade-off between reducing the C_{DS} capacitance and increasing the on-state resistance.

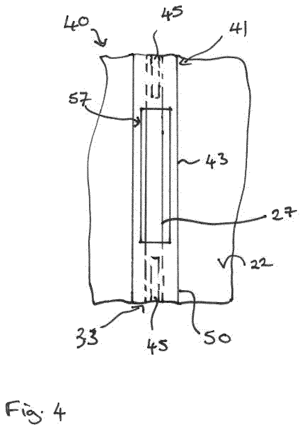

Figure 4 illustrates an arrangement for reducing the area of overlap between the section of the source finger 43 arranged under the drain bus 47 and the drain bus and illustrates a top view of a portion of the lower first electrically conductive layer 41 of the metallization structure 40, one source finger 43 and the underlying source contact 27 and conductive contact via 45.

In this embodiment, the area of overlap between the second section 50 of the source finger 43, which is arranged under the drain bus 47, and the drain bus 47 is reduced by introducing one or more openings or apertures 57 within the source finger 43 in the section 51 of the source finger 43 that is arranged under the drain bus 47. The opening 57 may be elongate and strip-like and is located intermediate the length and width of the source finger 43. In these embodiments, the conductive via 45 formed between the source contact 27 of the die conductive layer 33 and the overlying source finger 43 of the first conductive layer 41 of the metallization structure 40 is interrupted in a section under the aperture 57 such that the contact via 45 includes a plurality of sections which are spaced apart from one another along the length of the source contact 27. Similarly, one or more apertures may also be located intermediate the length and width of the drain finger 44 and within the second section 52 of the drain finger 44 which is arranged under the source bus 46. The conductive via 45 formed between the drain contact 28 of the die conductive layer 33 and the overlying drain finger 44 of the first conductive layer 41 of the metallization structure 40 is interrupted in a section under the aperture such that the contact via 45 includes a plurality of sections which are spaced apart from one another along the length of the drain contact 28.

A combination of one or more openings 57 introduced intermediate the length and width of the source fingers 33 and drain fingers 34 may be used in combination with a reduced width of the source fingers 33 and drain fingers 34 as described with reference to figures 2D and 3B, for example.

In the embodiments described above, the area of overlap between the source fingers 43 and overlying drain bus 47 and/or between the drain fingers 44 and overlying source bus 46 is reduced by reducing the area of the source fingers 43 and drain fingers in the lower first electrically conductive layer 41 of the metallization structure 40. In other embodiments, which may be used in addition to or in place of these embodiments, the area of overlap between the source fingers 43 and overlying drain bus 47 and/or between the drain fingers 44 and overlying source bus 46 is reduced by reducing the area of the source bus 46 and drain bus 47 in the upper second electrically conductive layer 42 of the metallization structure 40.

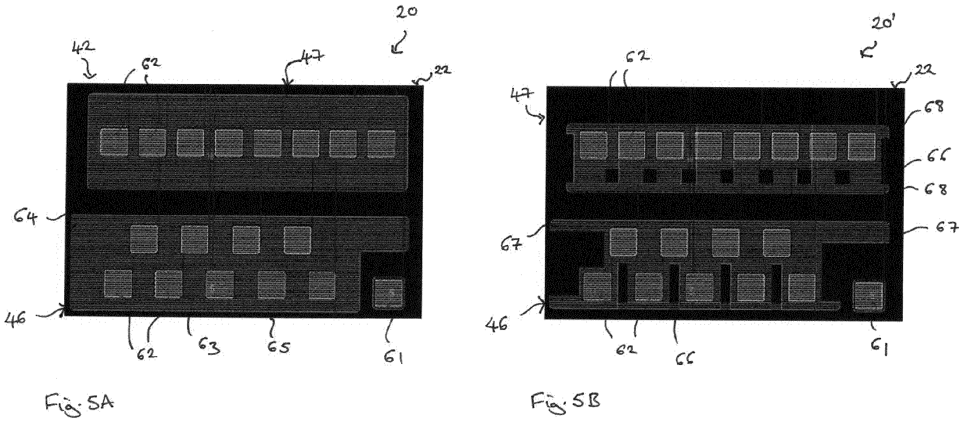

Figure 5A illustrates a top view of a comparison Group III nitride transistor device 20, 50, which may have an arrangement as shown in figures 2A or 3A. Figure 5A illustrates the upper second conductive layer 42 of the metallization structure 40 including the drain bus 47, the source bus 46 and a gate pad 61 which is also part of the second conductive layer 42.

The drain bus 47 has a rectangular form and comprises one or more contact areas 62. A contact area 62 may be formed by an area of the upper surface of the drain bus 47 that is exposed by an opening 63 in the passivation layer 64 which covers the surface of the source bus 46, drain bus 47, gate pad 61 and the upper surface of the Group III nitride transistor device 20, 50. In some embodiments, the exposed contact areas 62 include one or more further metallic layers for promoting adhesion with a bond wire or for improving the wettability and adhesion with solder. The gate pad 61 may be arranged in a corner of the first major surface 22 of the transistor device 20, 50 or may be arranged intermediate the length of the side of the first major surface 22 towards the periphery 65 of the first major surface 22. The source bus 43 has a substantially rectangular form and may extend around, and be laterally spaced apart from, the gate pad 61. The source bus 46 also comprises one or more contact areas 62.

Figure 5B illustrates a Group III nitride transistor device 20', 50' according to an embodiment in which the area of overlap between the source bus 46 and the underlying sections of the drain fingers 44 and between the drain bus 47 and the underlying sections of the source fingers 43 has been reduced over that illustrated in figure 5A by reducing the area of the source bus 46 and/or the drain bus 47. The source fingers 43 and drain fingers 44 of the first conductive layer 41 of the metallization structure 40 as well as the Group III nitride substrate 21 with its die conductive layer 33 and passivation layer 34 may have the form described with reference to and illustrated in figures 2 or 3.

The area of the source bus 46 and drain bus 47 may be reduced by introducing one or more apertures 66 and/or removing peripheral regions of the source bus 46 and of the drain bus 47. At least a section 67 of the source bus 46 extends above each of the underlying source fingers 43 of the transistor cells 26 so as to allow the conductive via 49 to be formed between the underlying second section 50 of each of the source fingers 43 and the source bus 46. Similarly, at least section 68 of the drain bus 47 extends above each of the drain fingers 44 so as to allow the conductive via 49 to be formed between each of the underlying first sections 52 of the drain fingers 44 and the drain bus 47.

The aperture(s) 57 may be situated and the outer contour of the source bus 46 and drain bus 47 positioned such that the positions of the contact areas 62 remain in a predetermined position, for example the positions shown in figure 5A.

The output capacitance of the metallization structure 40 may be reduced by reducing the area of the overlap between the source fingers 43 and overlying drain bus 47 and drain fingers 44 and overlying source bus 46 without increasing the thickness of the interlayer dielectric 48 arranged between them.

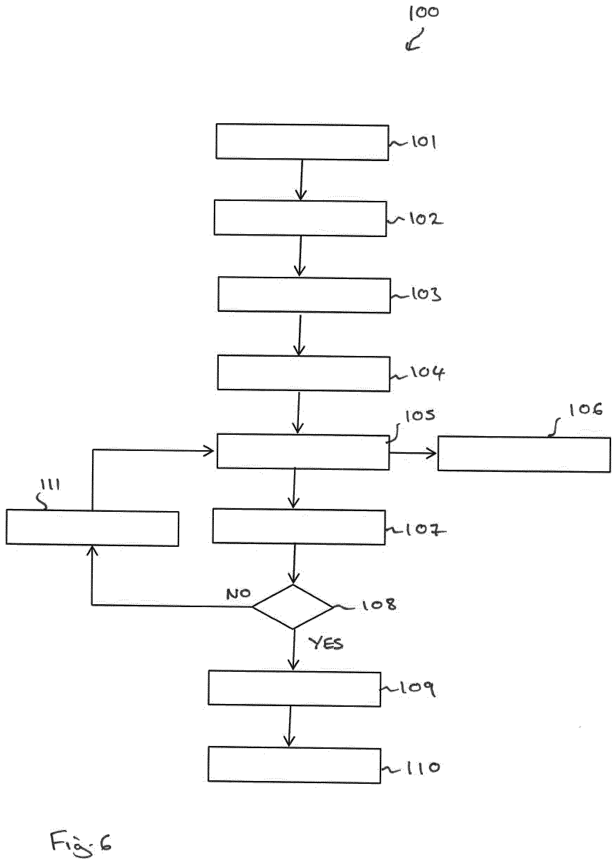

Figure 6 illustrates a flow diagram 100 of a method of fabricating a Group III transistor device. This method may be used to fabricate the Group III nitride transistor device of any one of the embodiments described herein including the Group III nitride transistor devices 20' and 50'.

In block 101, a lateral Group III nitride transistor is provided that has an initial design. The initial design comprises a Group III nitride substrate comprising first major surface, a Group III nitride channel layer and a Group III nitride barrier layer on the Group III nitride channel layer forming a heterojunction therebetween, a plurality of transistor cells and a metallization structure on the first major surface comprising a first electrically conductive layer and a second electrically conductive layer arranged on the first electrically conductive layer. The first electrically conductive layer comprises for each transistor cell a source finger and a drain finger on the first major surface and the second electrically conductive layer comprises a source bus and a drain bus. The source bus extends between and electrically connects the source fingers of the plurality of transistor cells and extends over and is electrically insulated from the drain fingers such that for each transistor cell a first initial overlapping area between the drain finger of that transistor cell and the source bus is formed. The drain bus extends between and electrically connects the drain fingers of the plurality of transistor cells and extends over and is electrically insulated from the source fingers such that for each transistor cell a second initial overlapping area between the source finger of that transistor cell and the drain bus is formed.

In block 102, the capacitance between the source finger and the drain bus of the initial design and/or the capacitance between the drain finger and the source bus of the initial design is measured.

In block 103, the on-state resistance of the Group III nitride transistor device having the initial design is measured.

In block 104, the first initial overlapping area and/or second initial overlapping area is locally reduced and a first and/or second modified overlapping area and a modified design is formed. For example, the first initial overlapping area may be locally reduced by reducing the area of one or both of the source finger and the drain bus in the first initial overlapping area and/or the second initial overlapping area may be reduced by reducing the area of one or both of the drain finger and the source bus in the second initial overlapping area. In another example, in the initial design, the source finger has an initial width, an initial length and an initial lateral shape and the initial lateral shape is rectangular. The area of the source finger is reduced by reducing the initial width of the source finger in the first initial overlapping area without reducing the initial length, and/or by introducing an aperture intermediate the initial length and the initial width of the source finger in the first initial overlapping region and/or reducing the initial width by forming a tapering shape from the rectangular initial lateral shape in the first initial overlapping area. In another example, in the initial design, the drain finger has an initial width, an initial length and an initial lateral shape and the initial lateral shape is rectangular. The area of the drain finger is reduced by reducing the initial width of the drain finger in the second initial overlapping area without reducing the initial length, and/or by introducing an aperture intermediate the initial length and the initial width of the drain finger in the second initial overlapping region and/or reducing the initial width by forming a tapering shape from the rectangular initial lateral shape in the second initial overlapping area.

In the modified design, an area of overlap between the source finger and the source bus is greater than an area of overlap between the same source finger and the drain bus and/or an area of overlap between the drain finger and the drain bus is greater than an area of overlap between the same drain finger and the source bus.

In block 105, the new capacitance between the source finger and the drain bus in the modified design and/or the new capacitance between the drain finger and the source bus in the modified design is measured.

In block 106, a source finger and/or a drain finger is formed according to the modified design. For example, a lithographic mask or masks may be fabricated according to the modified design which are used to fabricate the source and/or drain finger of the first conductive layer of the metallization structure of a Group III nitride transistor device.

In an optional further method, after block 105, the method continues to block 107 rather than block 106 and the new on state resistance of the modified design is measured. The method then continues to decision block 108. If the new capacitance is less than the initial capacitance, and the on-state resistance is less than a predetermined threshold value (YES), the method proceeds to block 109 and the lateral size and shape of the source finger and/or of the drain finger and/or source bus and/or drain bus is output in a final design dataset. If in decision block 108, the new capacitance is less than the initial capacitance and the on-state resistance is equal to or greater than a predetermined threshold value (NO), the method proceeds to block 111 and the area of the source finger and/or drain finger, respectively, is increased and the method returns to block 105 followed by block 107. After block 109, the method continues to block 110 and a source finger and a drain finger are formed according to the final design dataset. For example, the final design dataset may be used to fabricate or structure suitable lithographic masks which are used for forming the metallization structure.

In an optional further method, which may be performed as part of block 104 or block 111, the drain bus has an initial area and the source bus has an initial area and the method further comprises forming at least one aperture in the drain bus and/or removing peripheral portions of the drain bus and/or forming at least one aperture in the source bus and/or removing peripheral portions of the source bus. Portions of the drain bus may be removed in regions laterally adjacent the distal ends of the source and drain fingers, and/or adjacent the length of the source and drain fingers and/or in the peripheral regions of the substrate. Portions of the source bus may be removed in regions laterally adjacent the distal ends of the source and drain fingers, and/or adjacent the length of the source and drain fingers and/or in the peripheral regions of the substrate.

Lateral Group III nitride transistor devices, for example HEMTs, are provided which are suitable for fast switching applications. These lateral Group III nitride transistor devices have a metallization structure with a structure which results in low Ron-losses and lower switching losses. To reduce the switching losses, the effect of the metallization structure on the output capacitance CDS is taken into account by suitable structuring of the metallization structure. The metallization may be designed as a compromise between Rₒₙ and output capacity C_{DS}.

In some embodiments, the width of the first lower drain metal layer is reduced in areas with a low current density and/or low Rₒₙ-influence and/or where a second source metal layer is above. In some embodiments, the width of the first source metal layer is reduced in areas with a low current density and/or low Rₒₙ-influence and/or where a second drain metal layer is above. These measures can be used without changing the thickness of the interlayer dielectric that is arranged between the two metal layers thus avoiding processes issues that may arise when forming conductive vias through thicker interlayer dielectrics.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A Group III nitride transistor device, comprising:
a Group III nitride substrate comprising first major surface, a Group III nitride channel layer and a Group III nitride barrier layer arranged on the Group III nitride channel layer and forming a heterojunction therebetween,
a plurality of transistor cells,
a metallization structure comprising a first electrically conductive layer and a second electrically conductive layer, wherein
the first electrically conductive layer comprises for each transistor cell a source finger and a drain finger on the first major surface, and
the second electrically conductive layer comprises a source bus and a drain bus, wherein the source bus extends between and electrically connects the source fingers of the plurality of transistor cells and extends over and is electrically insulated from the drain fingers and the drain bus extends between and electrically connects the drain fingers of the plurality of transistor cells and extends over and is electrically insulated from the source fingers,
wherein in at least one of the transistor cells an area of overlap between the source finger and the source bus is greater than an area of overlap between the same source finger and the drain bus and/or
wherein in at least one of the transistor cells an area of overlap between the drain finger and the drain bus is greater than an area of overlap between the same drain finger and the source bus.

2. A Group III nitride transistor device according to claim 1, wherein
the source fingers each have a length and a width and the width of a section of the source finger that is located under the drain bus is less than the width of a further section of that source finger that is located under the source bus and/or
the drain fingers each have a length and a width and the width of a section of the drain finger that is located under the source bus is less than the width of a further section of that drain finger that is located under the drain bus.

3. A Group III nitride transistor device according to claim 2, wherein
the section of the source finger that is located under the drain bus has a tapered shape and/or
the section of the drain finger that is located under the source bus has a tapered shape, and/or
the source finger comprises an opening intermediate its length and width and the opening is located under the drain bus, and/or
the drain finger comprises an opening intermediate its length and width and the opening is located under the source bus.

4. A Group III nitride transistor device according to any one of claims 1 to 3,
the source bus has a length and a width, the length extending substantially perpendicularly to the length of the source finger and the width being substantially the same above the source fingers and above the drain fingers and/or
the drain bus has a length and a width, the length extending substantially perpendicularly to the length of the source finger and the width being substantially the same above the source fingers and above the drain fingers.

5. A Group III nitride transistor device according to any one of claims 1 to 4, wherein each transistor cell further comprises a gate finger arranged on the first major surface and the gate fingers each have a length and a width, wherein the width of the gate finger located under the source bus and under the drain bus is substantially the same.

6. A Group III nitride transistor device according to any one of claims 1 to 5, wherein the metallization structure further comprises an electrically insulating layer arranged between the first and second electrically conductive layers, wherein at least two of the source fingers of the plurality of transistor cells are each electrically connected to the source bus by a conductive via that extends through the electrically insulating layer and/or wherein at least two of the drain fingers of the plurality of transistor cells are each electrically connected to the drain bus by a conductive via.

7. A Group III nitride transistor device according to any one of claims 2 to 6,
wherein the width of the source finger located under the source bus is greater than the width of the drain finger located under the drain bus.

8. A Group III nitride transistor device according to any one of claims 2 to 7,
wherein the source bus is spaced apart from the drain bus by a gap, wherein the width of the source finger located in the gap is substantially the same as the width of the source finger located under the source bus and/or the width of the drain finger located in the gap is substantially the same as the width of the drain finger located under the drain bus.

9. A Group III nitride transistor device according to any one of claims 1 to 8,
wherein the source bus and/or the drain bus comprises at least one aperture.

10. A method for fabricating a Group III nitride transistor, the method comprising:
providing a Group III nitride transistor having an initial design, the initial design comprising
a Group III nitride substrate comprising first major surface, a Group III nitride channel layer and a Group III nitride barrier layer forming a heterojunction therebetween,
a plurality of transistor cells,
a metallization structure comprising a first electrically conductive layer and a second electrically conductive layer, wherein the first electrically conductive layer comprises for each transistor cell a source finger and a drain finger on the first major surface, and the second electrically conductive layer comprises a source bus and a drain bus,
wherein the source bus extends between and electrically connects the source fingers of the plurality of transistor cells and extends over and is electrically insulated from the drain fingers such that for each transistor cell a first initial overlapping area between the drain finger and the source bus is formed, and
wherein the drain bus extends between and electrically connects the drain fingers of the plurality of transistor cells and extends over and is electrically insulated from the source fingers such that for each transistor cell a second initial overlapping area between the source finger and the drain bus is formed,
measuring the capacitance between the source finger and the drain bus in the initial design and/or measuring the capacitance between the drain finger and the source bus in the initial design;
measuring the on-state resistance of the Group III nitride transistor device in the initial design,
locally reducing the first and/or second initial overlapping area and forming a first and/or second modified overlapping area and a modified design;
measuring the new capacitance between the source finger and the drain bus in the modified design and/or measuring the new capacitance between the drain finger and the source bus in the modified design,
forming a source finer and/or a drain finger according to the modified design.

11. A method according to claim 10, wherein the first and/or second initial overlapping area is locally reduced by reducing the area of one or both of the source finger and the drain bus in the first initial overlapping area and/or reducing the area of one or both of the drain finger and the source bus in the second initial overlapping area.

12. A method according to claim 11, wherein in the initial design, the source finger has an initial width, an initial length and an initial lateral shape,
wherein the initial lateral shape is rectangular and the area of the source finger is reduced by reducing the initial width of the source finger in the first initial overlapping area without reducing the initial length, and/or by introducing an aperture intermediate the initial length and the initial width of the source finger in the first initial overlapping region and/or reducing the initial width by forming a tapering shape from the rectangular initial lateral shape in the first initial overlapping area.

13. A method according to any one of clams 10 to 12,
wherein the first initial overlapping area between the source finger and the drain bus is reduced compared to an area of overlap between the same source finger and the source bus and/or
the second initial overlapping area between the drain finger and the source bus is reduced compared to an area of overlap between the same drain finger and the drain bus.

14. A method according to any one of claims 10 to 13, wherein the drain bus has an initial area and the method further comprises:
forming at least one aperture in the drain bus and/or removing peripheral portions of the drain bus, wherein portions of the drain bus are removed in regions laterally adjacent the distal ends of the source and drain fingers, and/or adjacent the length of the source and drain fingers and/or in the peripheral regions of the substrate, and/or
forming at least one aperture in the source bus and/or removing peripheral portions of the source bus, wherein portions of the drain bus are removed in regions laterally adjacent the distal ends of the source and drain fingers, and/or adjacent the length of the source and drain fingers and/or in the peripheral regions of the substrate.

15. The method according to any one of claims 10 to 14, further comprising:
Step A
measuring the new on state resistance of the modified design;
if the new capacitance is less than the initial capacitance, and the on-state resistance is less than a predetermined threshold value, outputting the lateral size and shape of the source finger in a final design dataset;
if the if the new capacitance is less than the initial capacitance, and the on-state resistance is equal to or greater than a predetermined threshold value, increasing the area of the source finger and returning to step A
forming a source finger and a drain finger according to the final design dataset.
